# EUROPEAN PATENT APPLICATION

(11) **EP 4 848 315 A1**
(43) Date of publication of application: **02.12.2026**
(21) Application number: 25744872.0
(22) Date of filing: 10.01.2025
(51) Int. Cl.: H01G 5/01, G01R 27/06, H01G 5/013, H02P 8/14

(54) **DRIVE CONTROL DEVICE FOR VARIABLE VACUUM CAPACITOR**

(30) Priority: 24.01.2024 JP 2024008724
(71) Applicant: Meidensha Corporation, Tokyo 141-6029 (JP)
(72) Inventor: NISHIKIORI, Yuichi, Tokyo 141-6029 (JP); TATSUMI, Toshinori, Tokyo 141-6029 (JP); SHIMOKAWA, Takuya, Tokyo 141-6029 (JP); KAWASHIMA, Koji, Tokyo 141-6029 (JP); OGUMA, Kota, Tokyo 141-6029 (JP); KOZAKI, Keiki, Tokyo 141-6029 (JP)
(74) Representative: Müller-Boré & Partner Patentanwälte PartG mbB
(86) International application number: PCT/JP2025/000659
(87) International publication number: WO 2025/158940

(57) **Abstract**

A drive control device 10 for a variable vacuum capacitor 1 includes a motor 5, a resolver 6, and a control unit 8. The motor 5 drives a movable electrode of the variable vacuum capacitor 1. The resolver 6 detects the rotational position of the motor 5. The control unit 8 controls the rotation of the motor 5 on the basis of the rotational position detected by the resolver 6.

## Description

### Technical Field

The present invention relates to a technique for enhancing the control response speed of a vacuum variable capacitor, which is applied to a high-frequency matching circuit of a thin-film manufacturing device for semiconductors or FPDs (flat panel displays).

### Background Art

In order to enhance the control response speed of the capacitance of a vacuum variable capacitor, the vacuum variable capacitor is composed of a ball screw drive system in which a movable conductor is provided with a ball screw, and a movable end of a vacuum container is provided with a rotating part that is threadedly engaged with the ball screw and is capable of rotating (see a patent document 1).

### Prior Art Document(s)

### Patent Document(s)

Patent Document 1: Japanese Patent No. 4449574

### Summary of Invention

In recent years, with enhancement in performance of thin-film manufacturing devices, there has been a growing demand to quickly synchronize a commanded position and an actual position of a movable electrode of a vacuum variable capacitor with respect to a fixed electrode of the vacuum variable capacitor in order to arbitrarily control the capacitance of the vacuum variable capacitor at high speed.

In order to control the capacitance of the vacuum variable capacitor at higher speed, it is required to increase the size of a motor for moving the movable conductor back and forth. The increase of the size of the motor may increase a load on moving components of the movable electrode, which include the ball screw and the movable conductor, and may impair the durability of the vacuum variable capacitor. Furthermore, the speedup of the motor may cause a phenomenon in which the commanded position and the actual position are out of synchronism with each other (hereinafter referred to as loss-of-synchronism phenomenon), which may result in adversely affecting the control response speed of the capacitance of the vacuum variable capacitor.

In view of the foregoing, it is an object of the present invention to enhance the control response speed of the capacitance of a vacuum variable capacitor, and to extend the life of the vacuum variable capacitor.

According to one aspect of the present invention, a drive control device for a vacuum variable capacitor, includes: a motor structured to drive a movable electrode of the vacuum variable capacitor; a sensor structured to sense a rotational position of the motor; and a control section configured to control rotation of the motor based on the sensed rotational position.

According to one aspect of the present invention, the drive control device is configured wherein the sensor is a resolver.

According to one aspect of the present invention, the drive control device is configured wherein the vacuum variable capacitor is a ball screw driven vacuum variable capacitor.

According to one aspect of the present invention, the drive control device is configured wherein the motor is a stepping motor having a maximum static torque of 1.0 Nm or less.

According to one aspect of the present invention, the drive control device is configured wherein the motor is configured to be controlled at a rotation speed of 0 to 3300 rpm within an operating range of 0 to 10 rotations.

According to one aspect of the present invention, the drive control device is configured wherein a time required for the movable electrode to move from a first end of a movable range of the movable electrode to a second end of the movable range is 0.5 seconds or less.

According to the present invention described above, it is possible to enhance the control response speed of the capacitance of the vacuum variable capacitor, and extend the life of the vacuum variable capacitor.

### Brief Description of Drawings

FIG. 1 is a schematic diagram of a drive control device for a vacuum variable capacitor according to an embodiment of the present invention.
FIG. 2 is a schematic cross-sectional view of a coupling section for coupling the vacuum variable capacitor and a motor shown in FIG. 1.
FIG. 3 shows a result of a performance test of a motor rotational position control performed by the drive control device shown in FIG. 1.

### Mode(s) for Carrying Out Invention

The following describes an embodiment of the present invention with reference to the drawings.

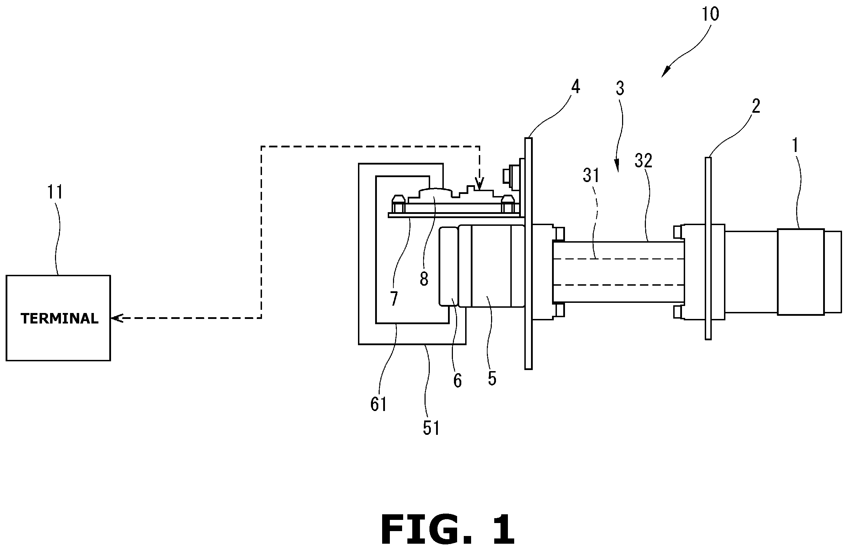

As shown in FIG. 1, a drive control device 10 for a vacuum variable capacitor 1 according to the present embodiment includes an electrical connection section 2, a coupling section 3, a support plate 4, a motor 5, a resolver 6, a support plate 7, and a control section 8.

In this example, the vacuum variable capacitor 1 is implemented by a ball screw drive type as disclosed in patent document 1.

The electrical connection section 2 electrically connects the vacuum variable capacitor 1 to a main circuit not shown.

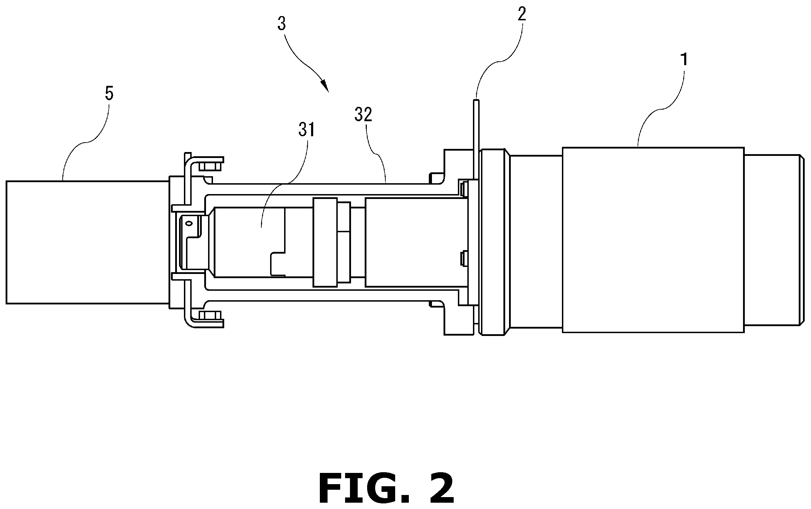

The coupling section 3 is supported on a face of the support plate 4 on a higher voltage side as shown in FIG. 1, and includes an insulating coupling 31 and an insulating housing 32 as shown in FIG. 2, wherein the insulating coupling 31 connects the vacuum variable capacitor 1 to the motor 5, and wherein the insulating housing 32 houses the insulating coupling 31. The insulating coupling 31 transmits a driving force of the motor 5 to a movable conductor that is connected to a movable electrode in the vacuum variable capacitor 1. The insulating housing 32 electrically insulates the vacuum variable capacitor 1 on the higher voltage side from the motor 5 on a lower voltage side, and houses the insulating coupling 31.

The motor 5 is supported on a face of the support plate 4 on the lower voltage side. The motor 5 drives a ball screw of the vacuum variable capacitor 1 through the insulating coupling 31 of the coupling section 3 based on a control signal from the control section 8 via a harness 51, and thereby allows the movable electrode to move back and forth along with the movable conductor of the vacuum variable capacitor 1. In this example, the motor 5 is implemented by a stepping motor with a maximum static torque of 1.0 Nm or less.

The resolver 6 is a sensor structured to sense a rotational position of the motor 5 and output the sensed rotational position to the control section 8 via a harness 61.

The control section 8 is supported on the support plate 7 that is attached to the higher-voltage side face of the support plate 4. The control section 8 controls the capacitance of the vacuum variable capacitor 1 by rotating the motor 5 based on a control signal from a terminal 11 and thereby moving the movable conductor in the vacuum variable capacitor 1. Furthermore, the control section 8 controls rotation of the motor 5 based on the rotational position of the motor 5 sensed by the resolver 6, thereby preventing the motor 5 from losing synchronism.

The following describes an example of operation of the present embodiment with reference to the same drawings.

The control section 8 receives a control signal for the motor 5 from the terminal 11 at regular intervals (for example, every 1 ms). The motor 5 operates based on a control signal received from the control section 8. For example, the control signal may be a position control command for controlling the rotational position of the motor 5, or a capacitance control command for controlling the capacitance formed between the fixed electrode and the movable electrode.

The motor 5 drives the ball screw of the vacuum variable capacitor 1 in accordance with the position control command or capacitance control command from the control section 8 to move the movable conductor.

The movement of the movable conductor in accordance with the position control command allows the movable electrode to be positioned with respect to the fixed electrode as desired. In this example where the motor 5 is a stepping motor, a unit of rotation of the motor 5 per count is set to 1/4000 rotation. A movable range of the movable electrode with respect to the fixed electrode in the vacuum variable capacitor 1 is set so that while the number of rotations of the motor 5 is from 0 to 10, the rotational position of the motor 5 sensed by the resolver 6 is from 0 to 40,000 counts. For example, when the motor 5 is controlled from a current position of 16,000 counts sensed by the resolver 6 to a command position of 20,000 counts, the motor 5 is controlled from the fourth rotation to the fifth rotation. The movable electrode is controlled by the motor 5 such that a time period of full stroke movement of the vacuum variable capacitor 1 (a time period when the movable electrode moves from the first end to the second end of the axial movable range of the movable electrode) is 0.5 seconds or less.

Furthermore, the movement of the movable conductor in accordance with the capacitance control command makes it possible to ensure a desired capacitance formed between the fixed electrode and the movable electrode. For example, the capacitance is arbitrarily controlled within a range of capacitance corresponding to rotational positions of 0 to 40,000 counts commanded by the control section.

Furthermore, the capacitance of the vacuum variable capacitor 1 is required to be controlled at high speed depending on the application. When controlling the capacitance at high speed, it is required to control operation of the motor 5 at high speed. According to the drive control device 10 according to the present embodiment, rotation of the motor 5 is controlled based on the rotational position of the motor 5 sensed by the resolver 6. This allows synchronism between the rotational position of the motor 5 commanded by the control section 8 (terminal 11) and the actual rotational position of the motor 5.

The operating state of the vacuum variable capacitor 1 due to the operation of the motor 5 (the rotational position and its control process, the capacitance and its control process) is successively transmitted to the terminal 11 via the control section 8. When an abnormality occurs in the vacuum variable capacitor 1 or the control section 8, an alarm is sent to the terminal 11.

According to the drive control device 10 for the vacuum variable capacitor 1 described above, rotation of the motor 5 is converted into linear motion by a drive component (ball screw), allowing the movable electrode to move back and forth within the vacuum variable capacitor 1 to vary the capacitance formed between the fixed electrode and the movable electrode.

With this device, even if the motor 5 is forced to undergo high load and high acceleration/deceleration when controlling the capacitance of the vacuum variable capacitor 1 at high speed, the desired capacitance can be quickly achieved by controlling the rotation of the motor 5 based on the rotational position sensed by the resolver 6, without loss of synchronism.

In particular, when the motor 5 is implemented by a stepping motor with a maximum static torque of 0.8 Nm or less, it is possible to reduce the size of the drive control device 10 while minimizing power consumption and avoiding loss-of-synchronism phenomena without increasing the size of the motor.

Furthermore, as compared to a drive control device for a vacuum variable capacitor 1 that employs no resolver 6 (for example, a drive control device for a vacuum variable capacitor 1 that employs an incremental encoder as a conventional position sensing mechanism with low accuracy or large delay), it is possible to carry out the control approximately 10 times as quickly, thereby achieving both faster capacitance control response and a longer life for the vacuum variable capacitor.

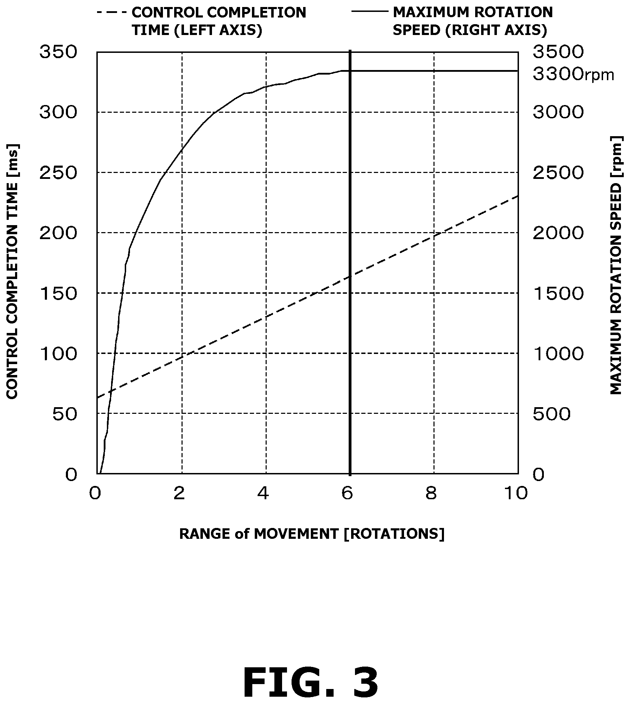

FIG. 3 shows a result of a performance test of the rotational position control of the motor 5 by the drive control device 10. FIG. 3 shows a time period for control completion and a maximum rotation speed when the motor 5 is within an operating range of 0 to 10 rotations, wherein the motor 5 has properties of a rated voltage of 24 V, a rated current of 1.7 A, a maximum input of 8.09 W, and a maximum static torque of 0.380 Nm. It was confirmed that high-speed control was achieved with a control completion time of 50 ms to 250 ms, a position control of 0.009 degrees, and a maximum rotation speed of 3300 rpm. This result suggests that the motor 5 can be controlled at a rotation speed of 0 to 3300 rpm in an operating range of 0 to 10 rotations. It is also suggested that the motor 5 can be controlled to move the movable electrode in its full stroke in 0.5 seconds or less.

The vacuum variable capacitor employed in the present invention is only required to be equipped with a drive component (ball screw or feed screw) for a movable conductor which can withstand high-speed operation of the motor 5. Therefore, the vacuum variable capacitor is not limited to a ball screw drive type and may be implemented by a feed screw drive type. Furthermore, the sensor employed in the present invention is not limited to a resolver, and may be a position sensing mechanism other than resolvers, since it is sufficient to employ one capable of sensing the rotational position of the motor with high accuracy and low delay.

### Description of Reference Signs

1... Vacuum variable capacitor
2... Electrical connection section
3... Coupling section, 31... Insulating coupling, 32... Insulating housing
4, 7... Support plates
5... Motor, 51... Harness
6... Resolver, 61... Harness
8... Control section
10... Drive control device
11... Terminal

## Claims

1. A drive control device (10) for a vacuum variable capacitor (1), comprising:
a motor (5) structured to drive a movable electrode of the vacuum variable capacitor (1);
a sensor (6) structured to sense a rotational position of the motor (5); and
a control section (8) configured to control rotation of the motor (5) based on the sensed rotational position.

2. The drive control device (1) according to claim 1, wherein the sensor (6) is a resolver.

3. The drive control device (1) according to claim 1, wherein the vacuum variable capacitor (1) is a ball screw driven vacuum variable capacitor.

4. The drive control device (10) according to claim 1, wherein the motor (5) is a stepping motor having a maximum static torque of 1.0 Nm or less.

5. The drive control device (10) according to claim 1, wherein the motor (5) is configured to be controlled at a rotation speed of 0 to 3300 rpm within an operating range of 0 to 10 rotations.

6. The drive control device (10) according to claim 1, wherein a time required for the movable electrode to move from a first end of a movable range of the movable electrode to a second end of the movable range is 0.5 seconds or less.
